(19) Europäisches Patentamt / European Patent Office / Office européen des brevets

(11) **EP 3 207 635 B1**

(12) **EUROPÄISCHE PATENTSCHRIFT**

(45) Veröffentlichungstag und Bekanntmachung des Hinweises auf die Patenterteilung:
**06.06.2018 Patentblatt 2018/23**

(21) Anmeldenummer: **15781337.9**

(22) Anmeldetag: **14.10.2015**

(51) Int Cl.:
*H03L 7/091* (2006.01)    *G01R 19/25* (2006.01)

(86) Internationale Anmeldenummer:
**PCT/EP2015/073736**

(87) Internationale Veröffentlichungsnummer:
**WO 2016/059089 (21.04.2016 Gazette 2016/16)**

(54) **PHASENDETEKTIONSVERFAHREN BASIEREND AUF EINER EMPFANGSSEQUENZ ABGETASTETER WERTE**

PHASE DETECTION METHOD BASED ON A RECEIVING SEQUENCE OF SCANNED VALUES

PROCÉDÉ DE DÉTECTION DE PHASE BASÉ SUR UNE SÉQUENCE DE RÉCEPTION DE VALEURS ÉCHANTILLONNÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.10.2014 DE 102014015126**

(43) Veröffentlichungstag der Anmeldung:
**23.08.2017 Patentblatt 2017/34**

(60) Teilanmeldung:
**18151321.9**

(73) Patentinhaber: **SoNovum AG**
**04103 Leipzig (DE)**

(72) Erfinder:
• **WROBEL, Miroslaw**
**97753 Karlstadt (DE)**
• **KOLANY, Adam**
**04317 Leipzig (DE)**

(74) Vertreter: **advotec.**
**Patent- und Rechtsanwälte**
**Beethovenstrasse 5**
**97080 Würzburg (DE)**

(56) Entgegenhaltungen:
WO-A1-2010/045979    US-A- 5 404 388
US-A- 5 854 995    US-B1- 6 246 267

• SYED MASUD MAHMUD ED - INSTITUTE OF ELECTRICAL AND ELECTRONICS ENGINEERS: "PHASE MEASUREMENT ALGORITHM USIG ADAPTIVE SAMPLING", INSTRUMENTATION AND MEASUREMENT TECHNOLOGY CONFERENCE. WASHINGTON, APRIL 25 - 27, 1989; [PROCEEDINGS OF THE INSTRUMENTATION AND MEASUREMENT TECHNOLOGY CONFERENCE], NEW YORK, IEEE, US, Bd. CONF. 6, Nr. 1989, 25. April 1989 (1989-04-25), Seiten 219-222, XP000041365,

## Beschreibung

Die vorliegende Erfindung betrifft ein Phasendetektionsverfahren und einen Prozessor zum Bestimmen einer Phase eines Empfangssignals basierend auf einer Empfangssequenz abgetasteter Werte.

Die US 5 404 388 A beschreibt ein Phasendetektionsverfahren, wobei eine Empfangssequenz von mit einer Abtastfrequenz abgetasteten Werten eines Empfangssignals empfangen wird, und wobei das Empfangssignal eine Reaktion auf ein Sendesignal mit einer bekannten Sendefrequenz darstellt.

Die genaue Bestimmung der Phase eines Ausgangssignals am Ausgang eines Übertragungsmediums bei Anregung am Eingang mit einem Eingangssignal bekannter Frequenz ist für eine Vielzahl von Anwendungen von Bedeutung. Beispielsweise kann die Phaseninformation in Kodierverfahren der Nachrichtentechnik dazu genutzt werden, um Nachrichten in Form von elektrischen, magnetischen oder elektro-magnetischen Signalen über einen Kommunikationskanal zu übertragen. Im Bereich der Materialwissenschaften gibt die Messung der Phase einer akustischen Welle Aufschluss über die Materialeigenschaften des Übertragungsmediums. In chemischen und physikalischen Analysesystemen werden Phasendetektoren genutzt, um Temperatur, Dichte, Phasenänderungen chemischer Reaktionen, Objektdimensionen und Flüssigkeitskonzentration in chemischen und physikalischen Medien zu bestimmen. In medizinischen Diagnostizierverfahren werden Eigenschaften von Geweben durch Messung der Phase von eingekoppelten akustischen und Ultraschall- Signalen ermittelt. Anwendungen hierzu sind die Überwachung der Blutzirkulation im Körper zur Erkennung krankhafter Zustände, insbesondere im Gehirn, und die Mammasonographie.

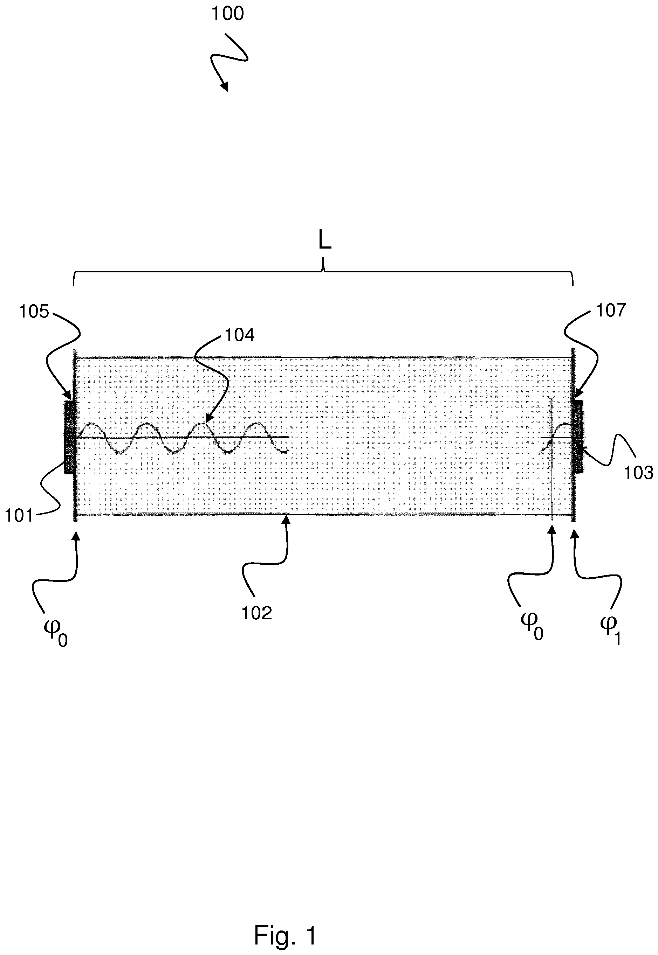

Fig. 1 zeigt eine schematische Darstellung eines Systems 100 zur Messung von Phasenbeziehungen akustischer Wellen in einem Gefäß 102. Das System 100 umfasst ein zu messendes Gefäß 102, beispielsweise eine Körperzelle, ein Blutgefäß oder eine Ader mit einer Gefäßlenge L und einen Sender 101 und Empfänger 103 von Ultraschallwellen. Der Sender 101 koppelt eine Ultraschallwelle 104 einer bekannten Frequenz $f_0$ mit Phase $\varphi_0$ an einem Eingang 105 des Gefäßes 102 in das Gefäß 102 ein, wo sie sich ausbreitet und am Ausgang 107 von dem Empfänger 103 empfangen wird. Wie aus Fig. 1 zu sehen ist, weist die Ultraschallwelle 104 in dem Gefäß 102 eine ganzzahlige Anzahl von Schwingungsperioden P auf sowie eine Teilperiode, die als Phasendifferenz $\varphi_1$-$\varphi_0$ dargestellt werden kann. Zwischen der Laufzeit $T_p$ der akustischen Welle 104 und der Phasendifferenz $\varphi_1 - \varphi_0$ gilt die folgende Beziehung:

$$2\pi \cdot f_0 T_P = 2\pi P + (\varphi_1 - \varphi_0) \qquad (1)$$

Für die Phasengeschwindigkeit $V$ in dem Gefäß 102 gilt einerseits die Beziehung

$$V = \lambda \cdot f_0 \ , \qquad (2)$$

wobei $f_0$ die bekannte Sendefrequenz und $\lambda$ die Wellenlänge im Gefäß 102 bezeichnet.

Andererseits gilt für die Phasengeschwindigkeit $V$ in dem Gefäß 102 die Beziehung

$$V = \sqrt{\frac{K}{\rho}} \ , \qquad (3)$$

wobei $K$ die Elastizität des Gefäßes und $\rho$ seine Dichte angibt. Aus der Phasengeschwindigkeit $V$ lassen sich somit die Eigenschaften des Gefäßes 102 bestimmen. Die Wellenlänge $\lambda$ lässt sich aus der Anzahl der Perioden $P$ und der Phasendifferenz $\varphi_1$ -$\varphi_0$ bestimmen und mittel der bekannten Sendefrequenz $f_0$ lässt sich die Phasengeschwindigkeit $V$ ermitteln, mit sich die Materialeigenschaften des Gefäßes 102 charakterisieren lassen.

Üblicherweise wird zum Bestimmen der Phasendifferenz $\varphi_1 - \varphi_0$ der Empfänger mit dem Sender synchronisiert und über einen Analog-Digitalwandler das empfangene Signal abgetastet. Der Abtastwert des empfangenen Signals kann mit dem Synchronisationszeitpunkt in Beziehung gesetzt werden und daraus lässt sich die Phasendifferenz bestimmen.

Allerdings ist die Messgenauigkeit von einer Vielzahl an Systemparametern abhängig, wie beispielsweise der Genauigkeit der Abtastung, der Genauigkeit der Frequenzeinstellung des Sendesignals, Genauigkeit der Einkopplung und Auskopplung des akustischen Signals, Interferenzen des Sendesignals aufgrund Reflektionen an den Gefäßenden und Gefäßseiten, Dopplereffekten etc.

Es ist die Aufgabe der vorliegenden Erfindung, ein Konzept für eine einfache und präzise Bestimmung der Phase am Ausgang eines Übertragungsmediums bei Anregung mit einem Sendesignal bekannter Signalcharakteristik zu schaffen.

Diese Aufgabe wird durch die Merkmale der unabhängigen Ansprüche gelöst. Vorteilhafte Weiterbildungsformen sind Gegenstand der abhängigen Ansprüche.

Die im Folgenden vorgestellten Verfahren, Vorrichtungen und Systeme können von verschiedener Art sein. Die einzelnen beschriebenen Elemente können durch Hardware- oder Softwarekomponenten realisiert sein, beispielsweise elektronische Komponenten, die durch verschiedene Technologien hergestellt werden können und zum Beispiel Halbleiterchips, ASICs, Mikroprozessoren, digitale Signalprozessoren, integrierte elektrische Schaltungen, elektrooptische Schaltungen und/oder passive Bauelemente umfassen.

Gemäß einem ersten Aspekt betrifft die Erfindung ein Phasendetektionsverfahren, mit folgenden Schritten: Empfangen einer Empfangssequenz von mit bekannter Abtastfrequenz $f_s$ abgetasteten Werten eines Empfangssignals, wobei das Empfangssignal eine Reaktion auf ein Sendesignal mit einer bekannten Sendefrequenz $f_w$ darstellt; Bereitstellen einer Sinussequenz und einer Kosinussequenz für jeden Index der Empfangssequenz, die Sinussequenz umfassend Sinuswerte aufeinanderfolgender Vielfacher einer bekannten Kreisfrequenz, welche von der Sendefrequenz $f_w$ und der Abtastfrequenz $f_s$ abhängt, und die Kosinussequenz umfassend Kosinuswerte aufeinanderfolgender Vielfacher der bekannten Kreisfrequenz; und Bestimmen eines Phasenrealteils des Empfangssignals basierend auf einem Skalarprodukt der Empfangssequenz mit der Kosinussequenz und eines Phasenimaginärteils des Empfangssignals basierend auf einem Skalarprodukt der Empfangssequenz mit der Sinussequenz.

Dies hat den Vorteil, dass die Phase am Ausgang eines Übertragungsmediums bei Anregung mit einem Sendesignal bekannter Signalcharakteristik einfach und präzise bestimmt werden kann. Bei bekannter Sendefrequenz und Abtastfrequenz sind die beiden Skalarprodukte mit geringem Aufwand zu bestimmen und liefern präzise Werte für die Phase des Empfangssignals.

Gemäß einer Ausführungsform des Phasendetektionsverfahrens ist ein Normierungsfaktor der beiden Skalarprodukte abhängig von einer Länge der Empfangssequenz.

Dies hat den Vorteil, dass nach Empfang jeder Empfangssequenz ein normiertes Skalarprodukt jeweils für Realteil und Imaginärteil der Phase auf einfache Weise bestimmt werden kann. Mit dem Normierungsfaktor kann ein exakter Wert für die Phase bestimmt werden.

Gemäß einer Ausführungsform des Phasendetektionsverfahrens ist die Abtastfrequenz $f_s$, mit der das Empfangssignal (Y) abgetastet wird, geringer ist als eine Nyquist-Shannon'sche Abtastfrequenz.

Das Abtasttheorem nach Shannon-Nyquist besagt, dass ein auf $f_{max}$ bandbegrenztes Signal mit einer Frequenz von mindestens $2 \cdot f_{max}$ abgetastet werden muss, damit man es aus dem zeitdiskreten Signal wieder exakt rekonstruieren kann. Nach dieser Ausführungsform des Phasendetektionsverfahrens ist das nicht mehr notwendig. Dies hat den Vorteil, dass die Abtastfrequenz $f_s$ unabhängig von den Eigenschaften des Übertragungsmediums gewählt werden kann.

Gemäß einer Ausführungsform des Phasendetektionsverfahrens ist die Abtastfrequenz $f_s$, mit der das Empfangssignal abgetastet wird, unabhängig von dem Nyquist-Shannon Abtasttheorem.

Gemäß einer Ausführungsform des Phasendetektionsverfahrens ist die Länge der Empfangssequenz multipliziert mit einem Quotienten aus der bekannten Sendefrequenz $f_w$ und der bekannten Abtastfrequenz $f_s$ ganzzahlig und eine Periode sowohl der Kosinussequenz als auch der Sinussequenz.

Dies hat den Vorteil, dass sich sowohl die Kosinussequenz als auch die Sinussequenz auf einfache Weise mit der Empfangssequenz multiplizieren lassen.

Gemäß einer Ausführungsform des Phasendetektionsverfahrens entspricht die Länge der Empfangssequenz einem Quotienten aus der Abtastfrequenz $f_s$ und dem kleinsten gemeinsamen Nenner aus der Abtastfrequenz $f_s$ und der Sendefrequenz $f_w$ oder einem Vielfachen des Quotienten.

Dies hat den Vorteil, dass sich die Terme in der Bestimmung des Skalarprodukts vereinfachen; einige werden zu Null, andere werden zu Konstanten. Damit lässt sich die Berechnung der Phase mit geringem Aufwand durchführen.

Gemäß einer Ausführungsform umfasst das Phasendetektionsverfahren ein Bestimmen eines Bias des Empfangssignals basierend auf einem Mittelwert der Empfangssequenz.

Dies hat den Vorteil, dass sich der Bias bzw. Offset des Empfangssignals auf einfache Weise durch Bestimmen des Mittelwerts der Empfangssequenz bestimmen lässt.

Gemäß einer Ausführungsform genügt die bekannte Kreisfrequenz $\Omega$ der folgenden Beziehung: $\Omega = 2\pi(f_w/f_s)$, wobei $f_w$ die bekannte Sendefrequenz und $f_s$ die bekannte Abtastfrequenz bezeichnet.

Gemäß einem zweiten Aspekt betrifft die Erfindung einen Prozessor zum Bestimmen einer Phase eines Empfangssignals, mit: einem N-stufigen Eingangsregister, das ausgelegt ist, eine Empfangssequenz von mit bekannter Abtastfrequenz $f_s$ abgetasteten Werten des Empfangssignals zu speichern, wobei das Empfangssignal eine Reaktion auf ein Sendesignal mit einer bekannten Sendefrequenz darstellt; jeweils N-stufigen ersten und zweiten Parameterregistern, die ausgelegt sind, eine Sinussequenz und eine Kosinussequenz zu speichern, die Sinussequenz umfassend Sinuswerte aufeinanderfolgender Vielfacher einer bekannten Kreisfrequenz, welche von der Sendefrequenz $f_w$ und der Abtastfrequenz $f_s$ abhängt, und die Kosinussequenz umfassend Kosinuswerte aufeinanderfolgender Vielfacher der bekannten Kreisfrequenz; einem ersten und zweiten Ausgangsregister, die ausgelegt sind, einen Phasenrealteil und einen Phasenimaginärteil des Empfangssignals bereitzustellen; und einer Recheneinheit, die ausgelegt ist, den Phasenrealteil des Empfangssignals basierend auf einem Skalarprodukt der Empfangssequenz mit der Sinussequenz und den Phasenimaginärteil des Empfangssignals basierend auf einem Skalarprodukt der Empfangssequenz mit der Kosinussequenz zu bestimmen.

Dies hat den Vorteil, dass ein solcher Prozessor die Phase am Ausgang eines Übertragungsmediums bei Anregung mit einem Sendesignal bekannter Signalcharakteristik einfach und präzise bestimmen kann. Bei bekannter Sendefrequenz und Abtastfrequenz kann der Prozessor die beiden Skalarprodukte mit geringem Aufwand bestimmen und präzise Werte für die Phase des Empfangssignals liefern.

Gemäß einer Ausführungsform des Prozessors ist ein Normierungsfaktor der beiden normierten Skalarprodukte 2/N, wobei N eine Länge der Empfangssequenz angibt.

Dies hat den Vorteil, dass nach Empfang jeder Empfangssequenz der Prozessor ein normiertes Skalarprodukt jeweils für Realteil und Imaginärteil der Phase auf einfache Weise bestimmen kann. Mit dem Normierungsfaktor kann der Prozessor einen exakten Wert für die Phase bestimmen.

Gemäß einer Ausführungsform umfasst der Prozessor ein drittes Ausgangsregister, das ausgelegt ist, einen Bias des Empfangssignals bereitzustellen, wobei die Recheneinheit ausgelegt ist, den Bias des Empfangssignals basierend auf einem Mittelwert der Empfangssequenz zu bestimmen.

Dies hat den Vorteil, dass der Prozessor den Bias bzw. Offset des Empfangssignals auf einfache Weise durch Berechnen des Mittelwerts der Empfangssequenz bestimmen kann.

Gemäß einer Ausführungsform genügt die bekannte Kreisfrequenz $\Omega$ der folgenden Beziehung: $\Omega = 2\pi(f_w/f_s)$, wobei $f_w$ die bekannte Sendefrequenz und $f_s$ die bekannte Abtastfrequenz bezeichnet.

Die Bestimmung der Phase und des Bias nach den hier beschriebenen Aspekten und Ausführungsbeispielen sind für eine Vielzahl von Anwendungen von Bedeutung. Beispielsweise kann die so bestimmte Phase bzw. der so bestimmte Bias in Kodierverfahren der Nachrichtentechnik dazu genutzt werden, um Nachrichten in Form von elektrischen, magnetischen oder elektro-magnetischen Signalen über einen Kommunikationskanal zu übertragen. Im Bereich der Materialwissenschaften kann die so bestimmte Phase bzw. der so bestimmte Bias in Bezug auf eine akustische Welle Aufschluss über die Materialeigenschaften des Übertragungsmediums geben. In chemischen und physikalischen Analysesystemen kann die so bestimmte Phase bzw. der so bestimmte Bias dazu genutzt werden, um Temperatur, Dichte, Phasenänderungen chemischer Reaktionen, Objektdimensionen und Flüssigkeitskonzentration in chemischen und physikalischen Medien zu bestimmen.

In medizinischen Diagnostizierverfahren kann bei eingekoppelten akustischen und Ultraschall- Signalen die nach den hier beschriebenen Aspekten und Ausführungsbeispielen bestimmte Phase bzw. Bias dazu genutzt werden, um Eigenschaften von Geweben zu ermitteln. Ausführungsbeispiele der Erfindung finden Anwendung beispielsweise bei der Überwachung der Blutzirkulation im Körper zur Erkennung krankhafter Zustände, insbesondere im Gehirn, und in der Mammasonographie. Die Phaseninformation kann hier Aufschluss geben sowohl über einen gesunden Zustand als auch einen kranken Zustand des Gewebes. Beispielsweise können mittels Messungen der Phase nach den hier vorgestellten Verfahren bzw. mit den hier vorgestellten Prozessoren an gesunden Patienten Informationen über einen gesunden Zustand des Gewebes gewonnen werden, die als eine Art Referenzwert dienen können. Bei Messungen an Patienten, bei denen die Phaseninformation gegenüber dem ermittelten Referenzwert abweicht, kann auf einen krankhaften Zustand des Patienten geschlossen werden.

Weitere Ausführungsbeispiele werden Bezug nehmend auf die beiliegenden Zeichnungen erläutert. Es zeigen:

Fig. 1 eine schematische Darstellung eines Systems 100 zur Messung von Phasenbeziehungen akustischer Wellen in einem Gefäß 102;

Fig. 2 eine schematische Darstellung eines Phasendetektionsverfahrens 200 gemäß einer Ausführungsform;

Fig. 3 eine schematische Darstellung eines Prozessors 300 zum Bestimmen einer Phase eines Empfangssignals gemäß einer ersten Ausführungsform;

Fig. 4 eine schematische Darstellung eines Prozessors 400 zum Bestimmen einer Phase eines Empfangssignals gemäß einer zweiten Ausführungsform; und

Fig. 5 eine schematische Darstellung eines Prozessors 500 zum Bestimmen einer Phase eines Empfangssignals gemäß einer dritten Ausführungsform.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

Wenngleich ein bestimmtes Merkmal oder ein bestimmter Aspekt einer Ausführungsform bezüglich nur einer von mehreren Implementierungen offenbart worden sein mag, kann außerdem ein derartiges Merkmal oder ein derartiger Aspekt mit einem oder mehreren anderen Merkmalen oder Aspekten der anderen Implementierungen kombiniert werden, wie für eine gegebene oder bestimmte Anwendung erwünscht und vorteilhaft sein kann. Weiterhin sollen in dem Ausmaß, in dem die Ausdrücke "enthalten", "haben", "mit" oder andere Varianten davon entweder in der ausführlichen Beschreibung oder den Ansprüchen verwendet werden, solche Ausdrücke auf eine Weise ähnlich dem Ausdruck "umfassen" einschließend sein. Die Ausdrücke "gekoppelt" und "verbunden" können zusammen mit Ableitungen davon verwendet worden sein. Es versteht sich, dass derartige Ausdrücke dazu verwendet werden, um anzugeben, dass zwei Elemente unabhängig davon miteinander kooperieren oder interagieren, ob sie in direktem physischem oder elektrischem Kontakt stehen oder nicht in direktem Kontakt miteinander stehen. Außerdem ist der Ausdruck "beispielhaft" lediglich als ein Beispiel aufzufassen anstatt der Bezeichnung für das Beste oder Optimale. Die folgende Beschreibung ist deshalb nicht in einem einschränkenden Sinne zu verstehen.

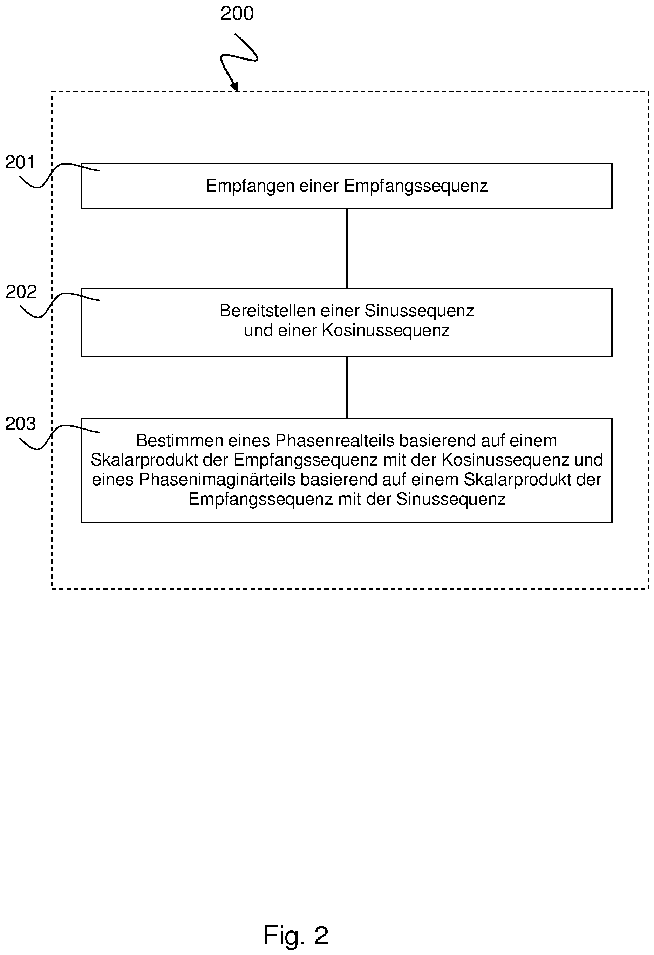

Fig. 2 zeigt eine schematische Darstellung eines Phasendetektionsverfahrens 200 gemäß einer Ausführungsform. Das Verfahren 200 umfasst ein Empfangen 201 einer Empfangssequenz $Y_j$ von mit bekannter Abtastfrequenz $f_s$ abgetasteten Werten $Y_0$, $Y_1$, .... $Y_{N-1}$ eines Empfangssignals Y, wobei das Empfangssignal Y eine Reaktion auf ein Sendesignal mit einer bekannten Sendefrequenz $f_w$ darstellt. Das Verfahren 200 umfasst ein Bereitstellen 202 einer Sinussequenz $S_j$ und einer Kosinussequenz $C_j$ für jeden Index j der Empfangssequenz $Y_j$, die Sinussequenz $S_j$ umfassend Sinuswerte aufeinanderfolgender Vielfacher einer bekannten Kreisfrequenz, welche von der Sendefrequenz $f_w$ und der Abtastfrequenz $f_s$ abhängt, und die Kosinussequenz $C_j$ umfassend Kosinuswerte aufeinanderfolgender Vielfacher der bekannten Kreisfrequenz. Das Verfahren 200 umfasst ein Bestimmen 203 eines Phasenrealteils U des Empfangssignals Y basierend auf einem Skalarprodukt der Empfangssequenz $Y_j$ mit der Kosinussequenz $C_j$ und eines Phasenimaginärteils V des Empfangssignals basierend auf einem Skalarprodukt der Empfangssequenz $Y_j$ mit der Sinussequenz $S_j$.

Die bekannte Kreisfrequenz $\Omega$ kann der Beziehung $\Omega = 2\pi(f_w/f_s)$ genügen. Ein Normierungsfaktor 2/N der beiden Skalarprodukte kann abhängig von einer Länge N der Empfangssequenz $Y_j$ sein. Die Abtastfrequenz $f_s$, mit der das Empfangssignal Y abgetastet wird, kann unabhängig von dem Nyquist-Shannon Abtasttheorem sein. Die Länge N der Empfangssequenz $Y_j$ multipliziert mit einem Quotienten aus bekannter Sendefrequenz $f_w$ und der bekannten Abtastfrequenz $f_s$ kann ganzzahlig sein und eine Periode sowohl der Kosinussequenz $C_j$ als auch der Sinussequenz $S_j$ sein. Die Länge N der Empfangssequenz $Y_j$ kann einem Quotienten aus der Abtastfrequenz $f_s$ und dem kleinsten gemeinsamen Nenner aus der Abtastfrequenz $f_s$ und der Sendefrequenz $f_w$ oder einem Vielfachen des Quotienten entsprechen.

Die folgende Darstellung beschreibt die theoretischen Grundlagen des Verfahrens 200.

Gegeben sei ein Vektor

$$Y_0, Y_1, ..., Y_{N-1} \tag{4}$$

von abgetasteten Werten der Funktion

$$Y(\tau) = \beta + A\sin(2\pi \cdot f_w \tau + \varphi) \tag{5}$$

bei der Abtastfrequenz $f_s$.

Die Näherungswerte der unbekannten Parameter

$A$, $\beta$ und $\varphi$

können zurückgewonnen werden durch Anwendung eines Least Squares Verfahrens (Verfahren der kleinsten Quadrate) unter Nutzung der folgenden Formeln:

$$\begin{bmatrix} Cov(S,Y) \\ Cov(C,Y) \end{bmatrix} = \begin{bmatrix} Cov(S,S) & Cov(S,C) \\ Cov(C,S) & Cov(C,C) \end{bmatrix} \times \begin{bmatrix} A\cos(\varphi) \\ A\sin(\varphi) \end{bmatrix}, \qquad (6a)$$

$$\beta = \overline{Y} - A \cdot (\overline{C}\sin(\varphi) + \overline{S}\cos(\varphi)), \qquad (6b)$$

wobei der Term

$$Cov(Z,T) = \overline{(Z - \overline{Z}) \cdot (T - \overline{T})} = \overline{ZT} - \overline{Z} \cdot \overline{T} \qquad (7)$$

eine Kovarianz der Sequenzen $Z$ und $T$
und der Sequenzen $S$ und $C$ darstellt, und
wobei $S$ und $C$ gegeben sind durch die Beziehungen:

$$S_j = \sin(2\pi \cdot (f_w / f_s) \cdot j), \quad j = 0,...,N-1 \qquad (8a)$$

$$C_j = \cos(2\pi \cdot (f_w / f_s) \cdot j), \quad j = 0,...,N-1 \qquad (8b)$$

Wie leicht zu sehen ist, ist für jedes N der Term

$$N \cdot (f_w / f_s) \in Z, \qquad (9)$$

eine Periode von beiden Sequenzen $\{S_j\}$ und $\{C_j\}$, Z die Menge der ganzen Zahlen bezeichnet.
Dann ist auch N eine Vielfaches von

$$\hat{f}_s = \frac{f_s}{ggT(f_s, f_w)}, \qquad (10)$$

wobei ggT den größten gemeinsamen Teiler bezeichnet und es gilt:

$$\overline{S} = \frac{1}{N} \cdot \sum_{j=0}^{N-1} S_j = 0, \; \overline{C} = \frac{1}{N} \cdot \sum_{j=0}^{N-1} C_j = 0, \; \overline{SC} = \frac{1}{N} \cdot \sum_{j=0}^{N-1} S_j C_j = 0 \qquad (11a)$$

$$\overline{S^2} = \frac{1}{N} \cdot \sum_{j=0}^{N-1} S_j^2 = \frac{1}{2} \text{ und } \overline{C^2} = \frac{1}{N} \cdot \sum_{j=0}^{N-1} C_j^2 = \frac{1}{2}. \qquad (11b)$$

Die Gleichung (6a) nimmt damit die folgende Form an:

$$\begin{bmatrix} \overline{S \cdot Y} \\ \overline{C \cdot Y} \end{bmatrix} = \begin{bmatrix} \dfrac{1}{2} & 0 \\ 0 & \dfrac{1}{2} \end{bmatrix} \times \begin{bmatrix} A\cos(\varphi) \\ A\sin(\varphi) \end{bmatrix} \qquad (12)$$

Somit gilt:

$$U = A\cos(\varphi) = 2 \cdot \overline{SY}, \qquad (13a)$$

$$V = A\sin(\varphi) = 2 \cdot \overline{CY} \qquad\qquad (13b)$$

und die gesuchten Werte können über die folgenden Beziehungen bestimmt werden:

$$A = \sqrt{U^2 + V^2}\,, \qquad\qquad (14a)$$

$$\varphi = (\arcsin(V/A)\bmod 2\pi)\,, \qquad\qquad (14b)$$

$$\beta = \overline{Y}\,. \qquad\qquad (14c)$$

Das Empfangen 201 der Empfangssequenz $Y_j$ von mit bekannter Abtastfrequenz $f_s$ abgetasteten Werten $Y_0$, $Y_1$, ..., $Y_{N-1}$ eines Empfangssignals Y des Verfahrens 200 lässt sich mit den Gleichungen (4) und (5) beschreiben.

Das Bereitstellen 202 einer Sinussequenz $S_j$ und einer Kosinussequenz $C_j$ für jeden Index j der Empfangssequenz $Y_j$ des Verfahrens 200 lässt sich durch die Gleichungen (8a), (8b), (9) und (10) beschreiben.

Das Bestimmen 203 eines Phasenrealteils U des Empfangssignals Y basierend auf einem Skalarprodukt der Empfangssequenz $Y_j$ mit der Kosinussequenz $C_j$ und eines Phasenimaginärteils V des Empfangssignals basierend auf einem Skalarprodukt der Empfangssequenz $Y_j$ mit der Sinussequenz $S_j$ des Verfahrens 200 lässt sich durch die Gleichungen (6a), (6b), (7) und (11a) bis (14c) beschreiben.

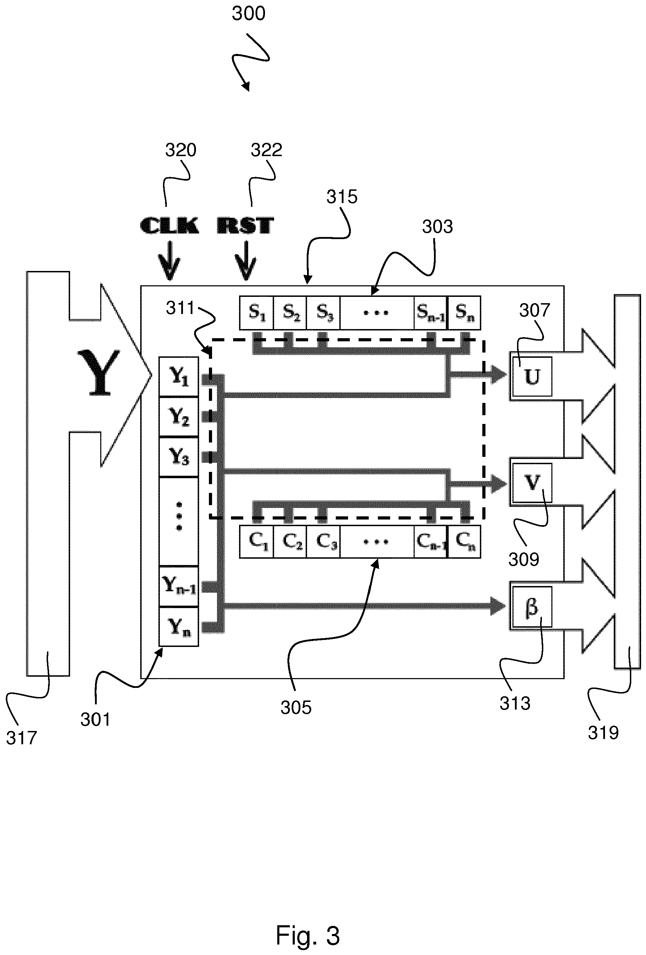

Fig. 3 zeigt eine schematische Darstellung eines Prozessors 300 zum Bestimmen einer Phase eines Empfangssignals gemäß einer ersten Ausführungsform.

Der Prozessor 300 umfasst ein N-stufiges Eingangsregister 301, ein N-stufiges erstes Parameterregister 303, ein N-stufiges zweites Parameterregister 305, ein erstes Ausgangsregister 307, ein zweites Ausgangsregister 309, ein drittes Ausgangsregister 313, eine Recheneinheit 311 und eine Instruktionseinheit 315. Der Prozessor 300 umfasst ferner einen Eingang für ein Taktsignal CLK 320 und einen Eingang für ein Reset-Signal RST 322. Der Prozessor 300 ist eingangsseitig mit einem Eingangsdatenbus 317 und ausgangsseitig mit einem Ausgangsdatenbus 319 gekoppelt.

Das N-stufige Eingangsregister 301 ist ausgelegt, eine Empfangssequenz $Y_j$ von mit bekannter Abtastfrequenz $f_s$ abgetasteten Werten $Y_0$, $Y_1$, ..., $Y_{N-1}$ des Empfangssignals Y zu speichern, wobei das Empfangssignal Y eine Reaktion auf ein Sendesignal mit einer bekannten Sendefrequenz $f_w$ darstellt.

Das N-stufigen erste Parameterregister 303 ist ausgelegt, eine Sinussequenz $S_j$ zu speichern, die Sinuswerte aufeinanderfolgender Vielfacher einer bekannten Kreisfrequenz $\Omega$, die von der Sendefrequenz $f_w$ und der Abtastfrequenz $f_s$ abhängt, umfasst. Das N-stufige zweite Parameterregister 305 ist ausgelegt, eine Kosinussequenz $C_j$ zu speichern, die Kosinuswerte aufeinanderfolgender Vielfacher der bekannten Kreisfrequenz $\Omega$ umfasst.

Die bekannte Kreisfrequenz $\Omega$ kann der Beziehung $\Omega = 2\pi(f_w/f_s)$ genügen.

Das erste Ausgangsregister 307 ist ausgelegt, einen Phasenrealteil U des Empfangssignals bereitzustellen. Das zweite Ausgangsregister 309 ist ausgelegt, einen Phasenimaginärteil V des Empfangssignals bereitzustellen.

Die Recheneinheit 311 ist ausgelegt, den Phasenrealteil U des Empfangssignals Y basierend auf einem Skalarprodukt der Empfangssequenz $Y_j$ mit der Sinussequenz $S_j$ zu bestimmen. Die Recheneinheit 311 ist ferner ausgelegt, den Phasenimaginärteil V des Empfangssignals Y basierend auf einem Skalarprodukt der Empfangssequenz $Y_j$ mit der Kosinussequenz $C_j$ zu bestimmen. Ein Normierungsfaktor der beiden Skalarprodukte kann als 2/N gewählt werden, wobei N eine Länge der Empfangssequenz $Y_j$ angibt.

Die Recheneinheit 311, die hier nur als gestrichelter Kasten angedeutet ist, kann arithmetisch-logische Einheiten zum Ausführen arithmetischer Operationen aufweisen. Sie kann Addierer, Multiplizierer und weitere Einheiten zum Ausführen von Rechenoperationen aufweisen.

Das dritte Ausgangsregister 313 ist ausgelegt, einen Bias des Empfangssignals Y bereitzustellen, der von der Recheneinheit 311 basierend auf einem Mittelwert der Empfangssequenz $Y_j$ bestimmt werden kann.

Der Prozessor 300 kann in Hardware oder in Software realisiert sein. Der Prozessor 300 kann eine Operationseinheit auf einem Chip bilden oder als Chip realisiert sein. Der Prozessor 300 kann ein digitaler Signalprozessor oder ein Mikrocontroller sein. Der Prozessor 300 kann als FPGA, als integrierte Schaltung, als ASIC oder als Teil dieser Bauelemente realisiert sein. Der Prozessor 300 kann in einem Empfänger oder als Teil einer Empfängerschaltung realisiert sein, beispielsweise einem Empfänger 103 wie in Figur 1 dargestellt.

Die Funktionsweise des Prozessors 300 kann wie folgt beschrieben werden.

Die in den beiden Parameterregistern 303, 305 gespeicherten Vektoren S und C enthalten jeweils die Sequenzen:

$$\sin(2\pi\sigma \cdot j), \quad j = 0,...,N-1 \text{ und} \tag{15a}$$

$$\cos(2\pi\sigma \cdot j), \quad j = 0,...,N-1, \tag{15b}$$

wobei $\sigma$ einen Quotienten aus der Signalfrequenz $f_w$ und der Abtastfrequenz $f_s$ bezeichnet:

$$\sigma = \frac{f_w}{f_s} = \frac{\hat{f}_w}{\hat{f}_s} \tag{16}$$

Nach Einschalten des Prozessors 300 bzw. nach Empfang des Reset-Signals RST 322 werden Daten vom Eingangsdatenbus 317 in das N-stufige Eingangsregister 301 übertragen. Die Ausgangsregister U und V werden jeweils mit den Werten

$$\frac{2}{N}Y \circ S \text{ und} \tag{17a}$$

$$\frac{2}{N}Y \circ C \tag{17b}$$

geladen, wobei Y die Sequenz abgetasteter Werte $Y_0$, $Y_1$, ..., $Y_{N-1}$ des Empfangssignals Y in Vektorform darstellt und S und C jeweils die Sinussequenz $S_j$ bzw. Kosinussequenz $C_j$ in Vektorform darstellt. Das Symbol $\circ$ bezeichnet das Skalarprodukt bzw. das innere Produkt zweier Vektoren.

Der Bias $\beta$ kann gemäß der folgenden Beziehung als Mittelwert über die Sequenz abgetasteter Werte $Y_0$, $Y_1$, ..., $Y_{N-1}$ des Empfangssignals Y bestimmt werden:

$$\overline{Y} = \frac{1}{N}\sum_{j=1...N}Y_j \tag{18}$$

und wird im dritten Ausgangsregister 313 gespeichert.

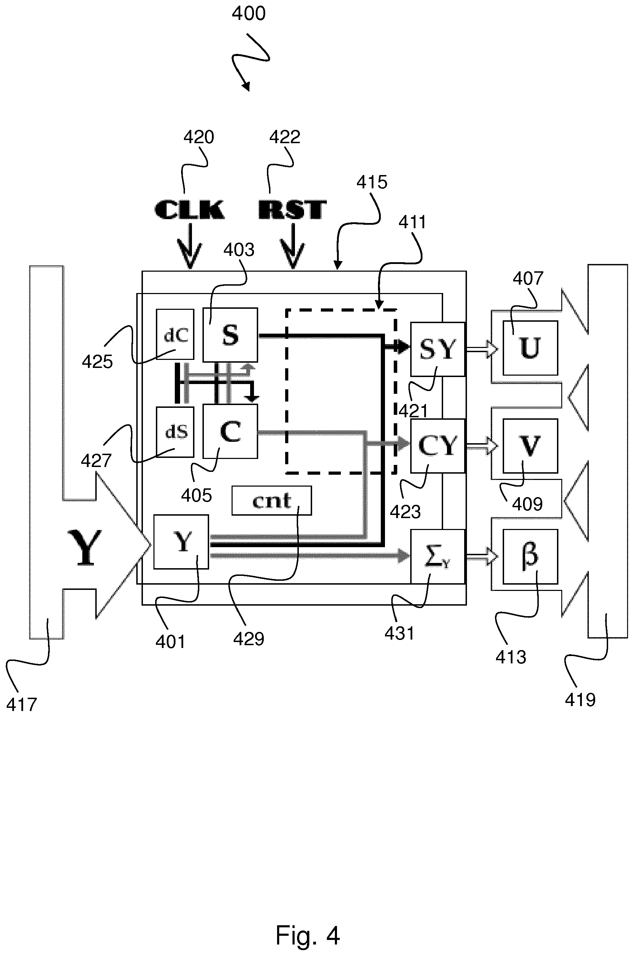

Fig. 4 zeigt eine schematische Darstellung eines Prozessors 400 zum Bestimmen einer Phase eines Empfangssignals gemäß einer zweiten Ausführungsform.

Der Prozessor 400 umfasst ein Eingangsregister 401, ein erstes Parameterregister 403, ein zweites Parameterregister 405, ein drittes Parameterregister 425, ein viertes Parameterregister 427, einen Zähler 429, ein erstes Ausgangsregister 407, ein zweites Ausgangsregister 409, ein drittes Ausgangsregister 413, ein erstes internes Register 421, ein zweites internes Register 423, ein drittes internes Register 431, eine Recheneinheit 411 und eine fnstruktionseinheit 415. Der Prozessor 311 umfasst ferner einen Eingang für ein Taktsignal CLK 420 und einen Eingang für ein Reset-Signal RST 422. Der Prozessor 400 ist eingangsseitig mit einem Eingangsdatenbus 417 und ausgangsseitig mit einem Ausgangsdatenbus 419 gekoppelt.

Das Eingangsregister 401 ist ausgelegt, einen Empfangswert eines mit bekannter Abtastfrequenz $f_s$ abgetasteten Empfangssignals Y zu speichern, wobei das Empfangssignal Y eine Reaktion auf ein Sendesignal mit einer bekannten Sendefrequenz $f_w$ darstellt.

Das erste Koeffizientenregister 403 ist ausgelegt, einen ersten Fourier-Koeffizienten S zu speichern, der eine lineare Beziehung zwischen dem Empfangssignal Y und einem Phasenrealteil des Empfangssignals Y angibt.

Das zweite Koeffizientenregister 405 ist ausgelegt, einen zweiten Fourier-Koeffizienten C zu speichern, der eine lineare Beziehung zwischen dem Empfangssignal Y und einem Phasenimaginärteil des Empfangssignals Y angibt.

Das ersten Ausgangsregister 407 ist ausgelegt, einen Phasenrealteil U des Empfangssignals Y bereitzustellen. Das zweite Ausgangsregister 409 ist ausgelegt, einen Phasenimaginärteil V des Empfangssignals Y bereitzustellen.

Die Recheneinheit 411 ist ausgelegt, den Phasenrealteil U des Empfangssignals Y basierend auf einem gemittelten Produkt des Empfangswertes mit dem Inhalt S des ersten Koeffizientenregisters 403 zu bestimmen. Die Recheneinheit 411 ist ausgelegt, den Phasenimaginärteil V des Empfangssignals Y basierend auf einem gemittelten Produkt des Empfangswertes mit dem Inhalt C des zweiten Koeffizientenregisters 405 zu bestimmen.

Die Recheneinheit 411, die hier nur als gestrichelter Kasten angedeutet ist, kann arithmetisch-logische Einheiten zum Ausführen arithmetischer Operationen aufweisen. Sie kann Addierer, Multiplizierer und weitere Einheiten zum Ausführen von Rechenoperationen aufweisen.

Die Instruktionseinheit 415 ist ausgelegt, ansprechend auf ein Reset-Signal 422 das zweite Koeffizientenregister 405 auf Eins zu setzen und die restlichen Register zu löschen. Die Instruktionseinheit 415 ist ausgelegt, ansprechend auf ein Takt-Signal 420 einen neuen Empfangswert des abgetasteten Empfangssignals Y zu speichern und das erste 403 und zweite 405 Koeffizientenregister mit neuen Koeffizienten S, C zu versorgen.

Die Recheneinheit 411 ist ferner ausgelegt, die gemittelten Produkte basierend auf einer zeitlichen Mittelung der abhängig von dem Taktsignal 420 jeweils vorliegenden Produkte aus dem Empfangswert und dem Inhalt S des ersten Koeffizientenregisters 403 bzw. dem Inhalt C des zweiten Koeffizientenregisters 405 zu bestimmen.

Die Instruktionseinheit 415 ist ausgelegt, ansprechend auf das Takt-Signal 420 das zweite Koeffizientenregister 405 mit dem Koeffizienten $dC \cdot C - dS \cdot S$ zu erneuern und das erste Koeffizientenregister 403 mit dem Koeffizienten $dC \cdot S + dS \cdot C$ zu erneuern. Hierbei gibt C den Inhalt des zweiten Koeffizientenregisters 405 an, S gibt den Inhalt des ersten Koeffizientenregister 403 an. Ferner gilt: $dC = \cos(\Omega)$ und $dS = \sin(\Omega)$ mit $\Omega = 2\pi^*(f_w/f_s)$. Die Werte dC und dS liegen jeweils in dem dritten Parameterregister 425 bzw. dem vierten Parameterregister 427 vor. Das Zählerregister 429 kann einen Zähler speichern zum Abzählen der Mittelwerte der gemittelten Produkte von Y mit S bzw. Y mit C.

Die Instruktionseinheit 415 ist ausgelegt, ansprechend auf das Takt-Signal 420 das erste interne Register 421 mit einem Produkt SY aus dem Inhalt des Eingangsregisters 401 und dem Inhalt S des ersten Koeffizientenregisters 403 zu inkrementieren. Die Instruktionseinheit 415 ist ausgelegt, ansprechend auf das Takt-Signal 420 das zweite interne Register 423 mit einem Produkt CY aus dem Inhalt des Eingangsregisters 401 und dem Inhalt C des zweiten Koeffizientenregisters 405 zu inkrementieren. Die Instruktionseinheit 415 ist ausgelegt, die jeweiligen Produkte mit einem Normierungsfaktor normiert in dem ersten 407 beziehungsweise zweiten 409 Ausgangsregister bereitzustellen.

Das dritte Ausgangsregister 413 ist ausgelegt, einen Bias $\beta$ des Empfangssignals Y bereitzustellen. Die Recheneinheit 411 ist ferner ausgelegt, den Bias $\beta$ des Empfangssignals Y basierend auf einer zeitlichen Mittelung des Inhalts des Eingangsregisters 401 zu bestimmen.

Der Prozessor 400 kann in Hardware oder in Software realisiert sein. Der Prozessor 400 kann eine Operationseinheit auf einem Chip bilden oder als Chip realisiert sein. Der Prozessor 400 kann ein digitaler Signalprozessor oder ein Mikrocontroller sein. Der Prozessor 400 kann als FPGA, als integrierte Schaltung, als ASIC oder als Teil dieser Bauelemente realisiert sein. Der Prozessor 400 kann in einem Empfänger oder als Teil einer Empfängerschaltung realisiert sein, beispielsweise einem Empfänger 103 wie in Figur 1 dargestellt.

Die Funktionsweise des Prozessors 400 kann wie folgt beschrieben werden.

Nach Einschalten des Prozessors 400 bzw. nach Empfang des Reset-Signals RST 422 wird der Prozessor mit der vorgegebenen Sendefrequenz $f_w$ und der vorgegebenen Abtastfrequenz $f_s$ betrieben. Der Zähler 429 wird entsprechend der Werte von $f_w$ und $f_s$ gesetzt. In einem Ausführungsbeispiel des Prozessors 400 wird die oben genannte Beziehung aus Gleichung (10) eingehalten, d.h. N ist gleich oder ein Vielfaches von $\hat{f}_s$:

$$\hat{f}_s = \frac{f_s}{ggT(f_s, f_w)}, \qquad (10)$$

Die internen Register 421, 423, 431 und das erste Parameterregister 403 werden gelöscht. Das zweite Parameterregister 405 empfängt den Wert Eins. Dann wird sukzessive ein Eingangswert im Eingangsregister 401 gespeichert, der zu dem dritten internen Register 431 hinzuaddiert wird. Dann wird das erste interne Register 421 mit dem Produkt $Y \times S$, d.h. dem Produkt der Inhalte des Eingangsregisters 401 und des ersten Koeffizientenregisters 403, inkrementiert; das zweite interne Register 423 wird mit dem Produkt $Y \times C$, d.h. dem Produkt der Inhalte des Eingangsregisters 401 und des zweiten Koeffizientenregisters 405, inkrementiert. Zugleich wird das erste interne Register 421 entsprechend der Vorschrift $S \leftarrow dC \cdot S + dS \cdot C$ modifiziert und das zweite interne Register 423 entsprechend der Vorschrift $C \leftarrow dC \cdot C - dS \cdot S$ modifiziert. Hierbei bezeichnen $dS$ und $dC$ Konstanten mit den Werten:

$$dS = \sin(\Omega), \qquad (19a)$$

$$dC = \cos(\Omega), \qquad (19b)$$

mit

$$\Omega = 2\pi\sigma \ . \tag{19c}$$

Der Zähler 429 wird verringert und nur wenn er gelöscht wird, werden die Inhalte der internen Register 421, 423, 431, d.h. die Werte

$$\frac{2}{N}SY \ , \ \frac{2}{N}CY \ , \ \frac{1}{N}\Sigma_Y$$

als U, V und $\beta$ in den jeweiligen Ausgangsregistern 407, 409, 413 gespeichert. U, V und $\beta$ können dann auch auf den Ausgangsdatenbus 419 übertragen werden.

Danach kann der Prozessor 400 durch Setzen des Reset-Signals 422 zurückgesetzt werden.

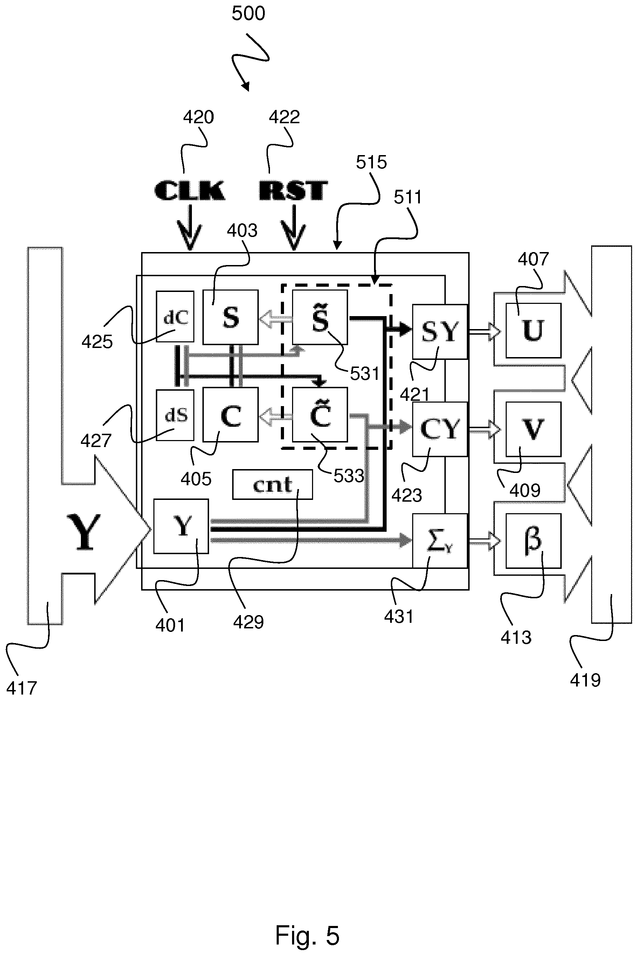

Fig. 5 zeigt eine schematische Darstellung eines Prozessors 500 zum Bestimmen einer Phase eines Empfangssignals gemäß einer dritten Ausführungsform.

Der Prozessor 500 entspricht dem Prozessor 400 bis darauf, dass er zwei zusätzliche interne Register aufweist, ein viertes internes Register 531 und ein fünftes internes Register 533. Entsprechend sind die Recheneinheit 511 und die Instruktionseinheit 515 zur Bearbeitung der damit verbundenen zusätzlichen Aufgaben anders ausgeführt.

Das vierte interne Register 531 und ein fünfte interne Register 533 können dazu verwendet werden, Zwischenergebnisse bei der Bestimmung der Produkte $Y \times S$ und $Y \times C$ zu speichern. So kann das vierte interne Register 531 den Wert $\tilde{S} = dC{\cdot}S + dS{\cdot}C$ bestimmen, der dann verwendet werden kann, um das erste interne Register 421 entsprechend der Vorschrift $S \leftarrow dC{\cdot}S + dS{\cdot}C$ bzw. $S \leftarrow \tilde{S}$ zu modifizieren.

Das fünfte interne Register 533 kann den Wert $\tilde{C} = dC.C - dS{\cdot}S$ bestimmen, der dann verwendet werden kann, um das zweite interne Register 423 entsprechend der Vorschrift $C \leftarrow dC{\cdot}C - dS{\cdot}S$ bzw. $C \leftarrow \tilde{C}$ zu modifizieren.

Der Prozessor 500 kann in Hardware oder in Software realisiert sein. Der Prozessor 500 kann eine Operationseinheit auf einem Chip bilden oder als Chip realisiert sein. Der Prozessor 500 kann ein digitaler Signalprozessor oder ein Mikrocontroller sein. Der Prozessor 500 kann als FPGA, als integrierte Schaltung, als ASIC oder als Teil dieser Bauelemente realisiert sein. Der Prozessor 500 kann in einem Empfänger oder als Teil einer Empfängerschaltung realisiert sein, beispielsweise einem Empfänger 103 wie in Figur 1 dargestellt.

Sowohl der Prozessor 300 gemäß der Beschreibung zu Figur 3 als auch die Prozessoren 400, 500 gemäß der Beschreibung zu den Figuren 4 und 5 eignen sich dazu, das in Fig. 2 beschriebene Verfahren 200 zu implementieren.

Ein Aspekt der Erfindung umfasst auch ein Computerprogrammprodukt, das direkt in den internen Speicher eines digitalen Computers geladen werden kann und Softwarecodeabschnitte umfasst, mit denen das zu Fig. 2 beschriebene Verfahren 200 ausgeführt werden kann, wenn das Produkt auf einem Computer läuft. Das Computerprogrammprodukt kann auf einem computergeeigneten Medium gespeichert sein und folgendes umfassen: computerlesbare Programmittel, die einen Computer veranlassen eine Empfangssequenz von mit bekannter Abtastfrequenz $f_s$ abgetasteten Werten eines Empfangssignals zu empfangen 201, wobei das Empfangssignal (Y) eine Reaktion auf ein Sendesignal mit einer bekannten Sendefrequenz $f_w$ darstellt; eine Sinussequenz und eine Kosinussequenz für jeden Index der Empfangssequenz bereitzustellen 202, die Sinussequenz umfassend Sinuswerte aufeinanderfolgender Vielfacher einer bekannten Kreisfrequenz $\Omega$, die von der Sendefrequenz $f_w$ und der Abtastfrequenz $f_s$ abhängt, und die Kosinussequenz umfassend Kosinuswerte aufeinanderfolgender Vielfacher der bekannten Kreisfrequenz; und einen Phasenrealteil des Empfangssignals basierend auf einem Skalarprodukt der Empfangssequenz mit der Kosinussequenz und einen Phasenimaginärteil des Empfangssignals basierend auf einem Skalarprodukt der Empfangssequenz mit der Sinussequenz zu bestimmen 203.

Der Computer kann ein PC sein, beispielsweise ein PC eines Computernetzwerks. Der Computer kann als ein Chip, ein ASIC, ein Mikroprozessor, ein Signalprozessor oder allgemein als ein Prozessor realisiert sein und beispielsweise als Prozessor wie in den Figuren 3 bis 5 beschrieben, implementiert sein.

Es ist selbstverständlich, dass die Merkmale der verschiedenen beispielhaft hierin beschriebenen Ausführungsformen miteinander kombiniert werden können, außer wenn spezifisch anderweitig angegeben. Wie in der Beschreibung und den Zeichnungen dargestellt müssen einzelne Elemente, die in Verbindung stehend dargestellt wurden, nicht direkt miteinander in Verbindung stehen; Zwischenelemente können zwischen den verbundenen Elementen vorgesehen sein. Ferner ist es selbstverständlich, dass Ausführungsformen der Erfindung in einzelnen Schaltungen, teilweise integrierten Schaltungen oder vollständig integrierten Schaltungen oder Programmiermitteln implementiert sein können. Der Begriff "beispielsweise" ist lediglich als ein Beispiel gemeint und nicht als das Beste oder Optimale. Es wurden bestimmte Ausführungsformen hierin veranschaulicht und beschrieben, doch für den Fachmann ist es offensichtlich, dass eine Vielzahl von alternativen und/oder gleichartigen Implementierungen anstelle der gezeigten und beschriebenen Ausführungsformen verwirklicht werden können, ohne vom Konzept der vorliegenden Erfindung abzuweichen.

**Bezugszeichenliste**

| | |
|---|---|
| 100: | System 100 zur Messung von Phasenbeziehungen akustischer Wellen in einem Gefäß |
| 101: | Sender |
| 102: | Gefäß |
| 103: | Empfänger |
| 104: | Ultraschallwelle |
| 105: | Eingang |
| 107: | Ausgang |
| | |
| 200: | Phasendetektionsverfahren 200 |
| 201: | 1. Verfahrensschritt: Empfangen |
| 202: | 2. Verfahrensschritt: Bereitstellen |
| 203: | 3. Verfahrensschritt: Bestimmen |
| | |
| 300: | Prozessor, geeignet zum Bestimmen einer Phase eines Empfangssignals |
| 301: | N-stufiges Eingangsregister |
| 303: | N-stufiges erstes Parameterregister |
| 305: | N-stufiges zweites Parameterregister |
| 307: | erstes Ausgangsregister |
| 309: | zweites Ausgangsregister |
| 311: | Recheneinheit |
| 313: | drittes Ausgangsregister |
| 315: | Instruktionseinheit |
| 317: | Eingangsdatenbus |
| 319: | Ausgangsdatenbus |
| 320: | Taktsignal |
| 322: | Reset-Signal |
| | |
| 400: | Prozessor, geeignet zum Bestimmen einer Phase eines Empfangssignals |
| 401: | Eingangsregister |
| 403: | erstes Parameterregister |
| 405: | zweites Parameterregister |
| 407: | erstes Ausgangsregister |
| 409: | zweites Ausgangsregister |
| 411: | Recheneinheit |
| 413: | drittes Ausgangsregister |
| 415: | Instruktionseinheit |
| 417: | Eingangsdatenbus |
| 419: | Ausgangsdatenbus |
| 420: | Taktsignal |
| 422: | Reset-Signal |
| 421: | erstes internes Register |
| 423: | zweites internes Register |
| 431: | drittes internes Register |
| 425: | drittes Parameterregister |
| 427: | viertes Parameterregister |
| 429: | Zähler |
| | |
| 500: | Prozessor, geeignet zum Bestimmen einer Phase eines Empfangssignals |
| 511: | Recheneinheit |
| 515: | Instruktionseinheit |
| 531: | viertes internes Register |
| 533: | fünftes internes Register |

**Patentansprüche**

1. Ein Phasendetektionsverfahren (200), mit folgenden Schritten:

   Empfangen (201) einer Empfangssequenz ($Y_j$) von mit bekannter Abtastfrequenz $f_s$ abgetasteten Werten ($Y_0$, $Y_1$, ..., $Y_{N-1}$) eines Empfangssignals (Y), wobei das Empfangssignal (Y) eine Reaktion auf ein Sendesignal mit einer bekannten Sendefrequenz $f_w$ darstellt;
   Bereitstellen (202) einer Sinussequenz ($S_j$) und einer Kosinussequenz ($C_j$) für jeden Index (j) der Empfangssequenz ($Y_j$), die Sinussequenz ($S_j$) umfassend Sinuswerte aufeinanderfolgender Vielfacher einer bekannten Kreisfrequenz ($\Omega$), welche von der Sendefrequenz $f_w$ und der Abtastfrequenz $f_s$ abhängt, und die Kosinussequenz ($C_j$) umfassend Kosinuswerte aufeinanderfolgender Vielfacher der bekannten Kreisfrequenz ($\Omega$); und
   Bestimmen (203) eines Phasenrealteils (U) des Empfangssignals (Y) basierend auf einem Skalarprodukt der Empfangssequenz ($Y_j$) mit der Kosinussequenz ($C_j$) und eines Phasenimaginärteils (V) des Empfangssignals basierend auf einem Skalarprodukt der Empfangssequenz ($Y_j$) mit der Sinussequenz ($S_j$).

2. Phasendetektionsverfahren (200) nach Anspruch 1,
   wobei ein Normierungsfaktor (2/N) der beiden Skalarprodukte abhängig von einer Länge (N) der Empfangssequenz ($Y_j$) ist.

3. Phasendetektionsverfahren (200) nach Anspruch 1 oder 2,
   wobei die Abtastfrequenz $f_s$, mit der das Empfangssignal (Y) abgetastet wird, geringer ist als eine Nyquist-Shannon'sche Abtastfrequenz.

4. Phasendetektionsverfahren (200) nach einem der vorstehenden Ansprüche,
   wobei die Länge (N) der Empfangssequenz ($Y_j$) multipliziert mit einem Quotienten aus der bekannten Sendefrequenz $f_w$ und der bekannten Abtastfrequenz $f_s$ ganzzahlig ist und eine Periode sowohl der Kosinussequenz ($C_j$) als auch der Sinussequenz ($S_j$) ist.

5. Phasendetektionsverfahren (200) nach einem der vorstehenden Ansprüche,
   wobei die Länge (N) der Empfangssequenz ($Y_j$) einem Quotienten aus der Abtastfrequenz $f_s$ und dem kleinsten gemeinsamen Nenner aus der Abtastfrequenz $f_s$ und der Sendefrequenz $f_w$ oder einem Vielfachen des Quotienten entspricht.

6. Phasendetektionsverfahren (200) nach einem der vorstehenden Ansprüche, mit:
   Bestimmen eines Bias des Empfangssignals (Y) basierend auf einem Mittelwert der Empfangssequenz ($Y_j$).

7. Phasendetektionsverfahren (200) nach einem der vorstehenden Ansprüche,
   wobei die bekannte Kreisfrequenz $\Omega$ der folgenden Beziehung genügt: $\Omega = 2\pi(f_w/f_s)$.

8. Prozessor (300) zum Bestimmen einer Phase eines Empfangssignals, mit:

   einem N-stufigen Eingangsregister (301), das ausgelegt ist, eine Empfangssequenz ($Y_j$) von mit bekannter Abtastfrequenz $f_s$ abgetasteten Werten ($Y_0$, $Y_1$, ..., $Y_{N-1}$) des Empfangssignals (Y) zu speichern, wobei das Empfangssignal (Y) eine Reaktion auf ein Sendesignal mit einer bekannten Sendefrequenz $f_w$ darstellt;
   jeweils N-stufigen ersten (303) und zweiten (305) Parameterregistern, die ausgelegt sind, eine Sinussequenz ($S_j$) und eine Kosinussequenz ($C_j$) zu speichern, die Sinussequenz ($S_j$) umfassend Sinuswerte aufeinanderfolgender Vielfacher einer bekannten Kreisfrequenz ($\Omega$), welche von der Sendefrequenz $f_w$ und der Abtastfrequenz $f_s$ abhängt, und die Kosinussequenz ($C_j$) umfassend Kosinuswerte aufeinanderfolgender Vielfacher der bekannten Kreisfrequenz ($\Omega$);
   einem ersten Ausgangsregister (307) und einem zweiten Ausgangsregister (309), die ausgelegt sind, einen Phasenrealteil (U) und einen Phasenimaginärteil (V) des Empfangssignals bereitzustellen; und
   einer Recheneinheit (311), die ausgelegt ist, den Phasenrealteil (U) des Empfangssignals (Y) basierend auf einem Skalarprodukt der Empfangssequenz ($Y_j$) mit der Sinussequenz ($S_j$) und den Phasenimaginärteil (V) des Empfangssignals (Y) basierend auf einem Skalarprodukt der Empfangssequenz ($Y_j$) mit der Kosinussequenz ($C_j$) zu bestimmen.

9. Prozessor (300) nach Anspruch 8,
   wobei ein Normierungsfaktor der beiden Skalarprodukte 2/N ist, wobei N eine Länge der Empfangssequenz ($Y_j$)

angibt.

10. Prozessor (300) nach Anspruch 7 oder 8, mit
einem dritten Ausgangsregister (313), das ausgelegt ist, einen Bias des Empfangssignals (Y) bereitzustellen,
wobei die Recheneinheit (311) ausgelegt ist, den Bias des Empfangssignals (Y) basierend auf einem Mittelwert der
Empfangssequenz ($Y_j$) zu bestimmen.

11. Prozessor (300) nach einem der Ansprüche 8 bis 10,
wobei die bekannte Kreisfrequenz $\Omega$ der folgenden Beziehung genügt: $\Omega = 2\pi(f_w/f_s)$.

**Claims**

1. A phase detection method (200), comprising the following steps:

receiving (201) a receiving sequence ($Y_j$) of values ($Y_0$, $Y_1$, ..., $Y_{N-1}$) of a receiving signal (Y), said values ($Y_0$, $Y_1$, ..., $Y_{N-1}$) having been sampled with a known sampling frequency $f_s$ and said receiving signal (Y) representing a reaction to a transmitting signal having a known transmitting frequency $f_w$;
providing (202) a sine sequence ($S_j$) and a cosine sequence ($C_j$) for each index (j) of the receiving sequence ($Y_j$), said sine sequence ($S_j$) comprising sine values of consecutive multiples of a known circular frequency ($\Omega$) which depends on the transmitting frequency $f_w$ and the sampling frequency $f_s$, and said cosine sequence ($C_j$) comprising cosine values of consecutive multiples of the known circular frequency ($\Omega$); and
determining (203) a phase real part (U) of the receiving signal (Y) based on a scalar product of the receiving sequence ($Y_j$) with the cosine sequence ($C_j$) and a phase imaginary part (V) of the receiving signal based on a scalar product of the receiving sequence ($Y_j$) with the sine sequence ($S_j$).

2. The phase detection method (200) according to claim 1,
wherein a normalization factor (2/N) of the two scalar products depends on a length (N) of the receiving sequence ($Y_j$).

3. The phase detection method (200) according to claim 1 or 2,
wherein the sampling frequency $f_s$, with which the receiving signal (Y) is sampled, is lesser than a Nyquist-Shannon sampling frequency.

4. The phase detection method (200) according to any one of the preceding claims,
wherein the length (N) of the receiving sequence ($Y_j$), which is multiplied by a quotient from the known transmitting frequency $f_w$ and the known sampling frequency $f_s$, is an integer and a period of the cosine sequence ($C_j$) as well as of the sine sequence ($S_j$).

5. The phase detection method (200) according to any one of the preceding claims,
wherein the length (N) of the receiving sequence ($Y_j$) corresponds to a quotient from the sampling frequency $f_s$ and the smallest common denominator from the sampling frequency $f_s$ and the transmitting frequency $f_w$ or to a multiple of the quotient.

6. The phase detection method (200) according to any one of the preceding claims, comprising:
determining a bias of the receiving signal (Y) based on a mean of the receiving sequence ($Y_j$).

7. The phase detection method (200) according to any one of the preceding claims,
wherein the known circular frequency $\Omega$ satisfies the following condition:

$$\Omega = 2\pi(f_w/f_s).$$

8. A processor (300) for determining a phase of a receiving signal, comprising:

an n-ary input register (301), which is configured for storing a receiving sequence ($Y_j$) of values ($Y_0$, $Y_1$, ..., $Y_{N-1}$) of the receiving signal (Y), said values ($Y_0$, $Y_1$, ..., $Y_{N-1}$) having been sampled with a known sampling frequency $f_s$ and said receiving signal (Y) representing a reaction to a transmitting signal having a known transmitting frequency $f_w$;

an n-ary first parameter register (303) and an n-ary second parameter register (305), respectively, which are configured for storing a sine sequence ($S_j$) and a cosine sequence ($C_j$), said sine sequence ($S_j$) comprising sine values of consecutive multiples of a known circular frequency ($\Omega$) which depends on the transmitting frequency $f_w$ and the sampling frequency $f_s$, and said cosine sequence ($C_j$) comprising cosine values of consecutive multiples of the known circular frequency ($\Omega$);

a first output register (307) and a second output register (309), which are configured for providing a phase real part (U) and a phase imaginary part (V) of the receiving signal; and

a computing unit (311), which is configured for determining the phase real part (U) of the receiving signal (Y) based on a scalar product of the receiving sequence ($Y_j$) with the sine sequence ($S_j$) and for determining the phase imaginary part (V) of the receiving signal (Y) based on a scalar product of the receiving sequence ($Y_j$) with the cosine sequence ($C_j$).

9. The processor (300) according to claim 8,
   wherein a normalization factor of the two scalar products is 2/N, wherein N denotes a length of the receiving sequence ($Y_j$).

10. The processor (300) according to claim 7 or 8, comprising:

   a third output register (313), which is configured for providing a bias of the receiving signal (Y),
   wherein the computing unit (311) is configured for determining the bias of the receiving signal (Y) based on a mean of the receiving sequence ($Y_j$).

11. The processor (300) according to any one of the claims 8 to 10,
    wherein the known circular frequency $\Omega$ satisfies the following condition:

$$\Omega = 2\pi(f_w/f_s).$$

## Revendications

1. Procédé de détection de phase (200), comprenant les étapes suivantes :

   réception (201) d'une séquence de réception ($Y_j$) de valeurs ($Y_0$, $Y_1$, ..., $Y_{N-1}$) d'un signal de réception (Y), lesdites valeurs ($Y_0$, $Y_1$, ..., $Y_{N-1}$) étant échantillonnées avec une fréquence d'échantillonnage $f_s$ connue et ledit signal de réception (Y) représentant une réaction à un signal de transmission ayant une fréquence de transmission $f_w$ connue;
   mise à disposition (202) d'une séquence sinus ($S_j$) et d'une séquence cosinus ($C_j$) pour chaque index (j) de la séquence de réception ($Y_j$), ladite séquence sinus ($S_j$) comprenant des valeurs sinus de multiples consécutifs d'une fréquence angulaire ($\Omega$) connue, qui dépend de la fréquence de transmission $f_w$ et de la fréquence d'échantillonnage $f_s$, et ladite séquence cosinus ($C_j$) comprenant des valeurs cosinus de multiples consécutifs de la fréquence angulaire ($\Omega$) connue ; et
   détermination (203) d'une partie réelle de phase (U) du signal de réception (Y) sur la base d'un produit scalaire de la séquence de réception ($Y_j$) avec la séquence cosinus ($C_j$) et d'une partie imaginaire de phase (V) du signal de réception sur la base d'un produit scalaire de la séquence de réception ($Y_j$) avec la séquence sinus ($S_j$).

2. Procédé de détection de phase (200) selon la revendication 1,
   dans lequel une facteur de normalisation (2/N) desdits deux produits scalaires dépend d'une longueur (N) de la séquence de réception ($Y_j$).

3. Procédé de détection de phase (200) selon la revendication 1 ou 2,
   dans lequel la fréquence d'échantillonnage $f_s$, au moyen de laquelle le signal de réception (Y) est échantillonné, est inférieure à une fréquence d'échantillonnage de Nyquist-Shannon.

4. Procédé de détection de phase (200) selon l'une quelconque des revendications précédentes,
   dans lequel la longueur (N) de la séquence de réception ($Y_j$), qui est multipliée par un quotient de la fréquence de transmission $f_w$ connue et la fréquence d'échantillonnage $f_s$, connue est un entier et est une période de la séquence cosinus ($C_j$) ainsi que de la séquence sinus ($S_j$).

**5.** Procédé de détection de phase (200) selon l'une quelconque des revendications précédentes, dans lequel la longueur (N) de la séquence de réception ($Y_j$) correspond à un quotient de la fréquence d'échantillonnage $f_s$ et au plus petit dénominateur commun de la fréquence d'échantillonnage $f_s$ et la fréquence de transmission $f_w$ ou à un multiple du quotient.

**6.** Procédé de détection de phase (200) selon l'une quelconque des revendications précédentes, comprenant l'étape suivante :
détermination d'un biais du signal de réception (Y) sur la base d'une moyenne de la séquence de réception ($Y_j$).

**7.** Procédé de détection de phase (200) selon l'une quelconque des revendications précédentes, dans lequel la fréquence angulaire $\Omega$ connue satisfait la condition suivante :

$$\Omega = 2\pi(f_w/f_s).$$

**8.** Processeur (300) pour déterminer une phase d'un signal de réception, comprenant :

un registre d'entrée (301) en nombres entiers, qui est configuré pour stocker une séquence de réception ($Y_j$) de valeurs ($Y_0$, $Y_1$, ..., $Y_{N-1}$) du signal de réception (Y), lesdites valeurs ($Y_0$, $Y_1$, ..., $Y_{N-1}$) étant échantillonnées avec une fréquence d'échantillonnage $f_s$ connue et ledit signal de réception (Y) représentant une réaction à un signal de transmission ayant une fréquence de transmission $f_w$ connue;
un premier registre de paramètre (303) en nombres entiers et un deuxième registre de paramètre (305) en nombres entiers, qui sont chacun configurés pour stocker une séquence sinus ($S_j$) et une séquence cosinus ($C_j$), ladite séquence sinus ($S_j$) comprenant des valeurs sinus de multiples consécutifs d'une fréquence angulaire ($\Omega$) connue, qui dépend de la fréquence de transmission $f_w$ et de la fréquence d'échantillonnage $f_s$, et ladite séquence cosinus ($C_j$) comprenant des valeurs cosinus de multiples consécutifs de la fréquence angulaire ($\Omega$) connue ;
un premier registre de sortie (307) et un deuxième registre de sortie (309), qui sont chacun configurés pour mettre à disposition une partie réelle de phase (U) et une partie imaginaire de phase (V) du signal de réception ; et
une unité de compte (311), qui est configurée pour déterminer la partie réelle de phase (U) du signal de réception (Y) sur la base d'un produit scalaire de la séquence de réception ($Y_j$) avec la séquence sinus ($S_j$) et pour déterminer la partie imaginaire de phase (V) du signal de réception (Y) sur la base d'un produit scalaire de la séquence de réception ($Y_j$) avec la séquence cosinus ($C_j$).

**9.** Processeur (300) selon la revendication 8, dans lequel un facteur de normalisation desdits deux produits scalaires est 2/N, dans lequel N désigne une longueur de la séquence de réception ($Y_j$).

**10.** Processeur (300) selon la revendication 7 ou 8, comprenant :

un troisième registre de sortie (313), qui est configuré pour mettre à disposition un biais du signal de réception (Y), dans lequel l'unité de compte (311) est configurée pour déterminer le biais du signal de réception (Y) sur la base d'une moyenne de la séquence de réception ($Y_j$).

**11.** Processeur (300) selon l'une quelconque des revendications 8 à 10, dans lequel la fréquence angulaire $\Omega$ connue satisfait la condition suivante :

$$\Omega = 2\pi(f_w/f_s).$$

100

L

105

104

107

101

103

102

$\varphi_0$

$\varphi_0$

$\varphi_1$

Fig. 1

200

Empfangen einer Empfangssequenz

Bereitstellen einer Sinussequenz
und einer Kosinussequenz

Bestimmen eines Phasenrealteils basierend auf einem
Skalarprodukt der Empfangssequenz mit der Kosinussequenz und
eines Phasenimaginärteils basierend auf einem Skalarprodukt der
Empfangssequenz mit der Sinussequenz

Fig. 2

300

320    322

315
303

CLK  RST

311

| $S_1$ | $S_2$ | $S_3$ | $\cdots$ | $S_{n-1}$ | $S_n$ |

307

$Y$

| $Y_1$ |
| $Y_2$ |
| $Y_3$ |
| $\vdots$ |
| $Y_{n-1}$ |
| $Y_n$ |

U

V

| $C_1$ | $C_2$ | $C_3$ | $\cdots$ | $C_{n-1}$ | $C_n$ |

309

$\beta$

317    301    305    313    319

Fig. 3

Fig. 4

Fig. 5

**EP 3 207 635 B1**

**IN DER BESCHREIBUNG AUFGEFÜHRTE DOKUMENTE**

**In der Beschreibung aufgeführte Patentdokumente**

- US 5404388 A